# EUROPEAN PATENT SPECIFICATION

(11) **EP 2 647 306 B1**
(45) Date of publication and mention of the grant of the patent: **13.11.2019**
(21) Application number: 13161921.5
(22) Date of filing: 02.04.2013
(51) Int. Cl.: A45C 11/00, G06F 1/16

(54) **Protective apparatus for tablet electronic device**
Schutzvorrichtung für elektronische Tafelvorrichtungen
Appareil de protection pour dispositif électronique à tablette

(30) Priority: 02.04.2012 US 201261619259 P; 20.02.2013 US 201313771781
(43) Date of publication of application: 09.10.2013
(73) Proprietor: Aevoe Inc., Taipei City 110, Taiwan (TW)
(72) Inventor: Shao, Tzu-Ching, 110 Taipei City (TW); Lin, Li-Wen, 110 Taipei City (TW)
(74) Representative: Becker Kurig Straus

(56) References cited:
- EP-A2- 2 560 071
- JP-U- 3 174 558
- US-A1- 2006 285 283

## Description

### FIELD OF THE INVENTION

The present invention generally relates to a protective apparatus, and more specifically to a protective apparatus for a tablet electronic device, such as, tablet PC, e-book, or the like so as to protect the surfaces of the electronic device when the device is not in use as well as to provide convenience for operation or viewing when the device is used.

### BACKGROUND OF THE INVENTION

With the development of information and communication technology, portable electronic devices such as notebook computers, mobile phones, smart phones, e-books, tablet PCs, etc., have become an integral part of life. Tablet electronic devices, such as touch screen tablet PCs, are especially popular recently because of the maturity of touch panel technology and the wide range of applications that have been developed to facilitate use thereof. Electronic readers, or commonly called as e-books, utilize new display technologies to avoid eye stress during long time reading, coupled with a large storage capacity to store a large number of book contents for the reader to choose from. As the unit price of a tablet electronic device is still relative high, the user often handles the product with extra caution and desires to purchase protective devices to prevent the tablet from damage.

In addition to preventing the surface of the electronic device from being scratched, a good protective apparatus should also take the convenience of operation of the device into account. For touch screen operation of a table electronic device, such as a tablet PC, the user usually holds the tablet electronic device in one hand, while using the other hand to operate the touch screen. As it is difficult for the user to hold the tablet electronic device for a long duration of use, the device is simply placed on a table or in the user's lap. Moreover, most of the tablet electronic devices embody functions that require them to be in a landscape or portrait viewing position for a prolonged period of time, such as playing back videos, and showing digital photos or slide shows.

US 7,561,415 to Liou et al. discloses an LCD display protective cover comprising a plurality of elements that can be arranged with a positioning means to provide adjustable view angles of the display.

US 20030112589 to Shimano et al. discloses a portable computer including a base unit coupled to a display unit so that the display unit can be moved relative to the base unit to place the portable computer in a closed configuration, a laptop configuration or a tablet configuration.

US 20110163642 assigned to Apple, Inc. discloses a case for securing and protecting an electronic device, which includes a tab that allows a user to fold open the cover of the case to form a triangular prism such that the device can be oriented towards a user in either landscape or portrait mode at particular angles.

US 20120194448 assigned to Apple, Inc. discloses a flexible cover for a tablet device, with thin flexible display technology integrated into the flexible cover without affecting the overall form factor of the cover or tablet device, to enhance the overall functionality of the tablet device. The flexible cover comprises a plurality of segments that can be folded with respect to each other to position the tablet device in the landscape mode at desired angles.

US 20120194308 assigned to Apple, Inc. discloses a protective cover for a tablet device comprising a plurality of elements that can be folded and fastened to each other by magnetic attachment mechanisms to form a display stand to position the tablet device in the landscape mode at a comfortable viewing angle.

EP 2476338A3 discloses a portable apparatus of the underlying context.

There is still a need for a portable apparatus that is capable of both effectively protecting a tablet portable electronic device when not in use, as well as to assist the user in holding and positioning the device in both the portrait and landscape viewing modes during operation. The present invention now meets these needs.

### SUMMARY OF THE INVENTION

The invention provides a portable apparatus according to claim 1 for storing and selectively positioning a portable electronic device in one of a plurality of viewing or operational positions comprising front and back covers and a connection member hingedly attached to each of the front and back covers. The front cover of the apparatus front cover made of a durable material and comprising first and second diagonals and a midline that define a plurality of cover segments that can be arranged in different positions to form three-dimensional structures for supporting the device by folding or bending the segments along the first and second diagonals and the midline. The back cover of the apparatus is adapted for removable interconnection with the electronic device. The connection member enables the apparatus to switch between open and closed configurations. In the closed configuration, the front cover shields the face of the portable electronic device for storage or transport, while in the open, folded configuration, the three-dimensional structures formed by the folded front cover act as supports for selectively positioning the portable electronic device in different arrangements for viewing or operation thereof.

The first and second diagonals and the midline are bendable structures that facilitate folding or bending to alter the position of the cover segments. These bendable structures may be score lines in the material of the cover or cover segments, or a hinge or resilient material that connects the cover segments wherein the resilient material is more easily bent or folded than the material of the cover or cover segments.

In one embodiment, each of the front and back covers has essentially the same dimension as that of the electronic device for compact engagement therewith. In another embodiment, the front and back covers have larger dimensions than the electronic device to provide additional protection against damage to the edges of the device.

In one embodiment, at least two segments of the front cover include fastening elements positioned for mating contact to hold the folded segments together after folding to assist in maintaining the three-dimensional structures. In one preferred embodiment, the fastening elements include a magnet and a metal that is capable of magnetic attraction to the magnet. In another preferred embodiment, the fastening elements are hook and loop fasteners.

In one embodiment, the device is rectangular, and the three-dimensional structures position the device for viewing in portrait or landscape mode and at different viewing angles.

In one embodiment, the three-dimensional structure of the front cover provides support for the back cover to stand with a tilt angle so that, when the electronic device is attached to the back cover via an attachment mechanism, it can operate in a landscape or portrait viewing position. Preferably, the attachment mechanism includes glue or an adhesive, one or more clips or a pocket that receives the electronic device.

In one embodiment, the durable material of the front cover is rubber, silicone, fabric, cardboard, metal, plastic, stiffened cloth, vinyl covered binder board, hardback book binding materials, leather, or a carbon fiber epoxy composite.

The invention also relates to a combination of a portable electronic device and the portable apparatus of the invention. In one embodiment, the device is a tablet that includes a touch screen and at least one camera lens. Thus, the front cover is foldable to expose the lens.

### BRIEF DESCRIPTION OF THE DRAWINGS

The present invention can be understood in more detail by reading the subsequent detailed description in conjunction with the examples and references made to the accompanying drawings, wherein:
Fig. 1 is a top plan view of a portable apparatus according to the present invention in an open position;
Figs. 2A-2E are back, left and right perspective views of a portable apparatus according to the present invention folded into a three-dimensional structure for supporting the device in landscape viewing position;
Figs. 3A and 3B are back and side perspective views of a portable apparatus according to the present invention folded into three-dimensional structures for supporting the device in landscape viewing position;
Figs. 4A-4D are back, left and right perspective views of a portable apparatus according to the present invention folded into three-dimensional structures for supporting the device in portrait viewing position;
Fig. 5 shows the top portion of a tablet portable electronic device encased in the portable apparatus according to the present invention which has been folded for photo taking; and
Fig. 6 shows the back view of a tablet portable electronic device with a portable apparatus according to the present invention which has been folded for photo taking.

### DETAILED DESCRIPTION OF THE PREFERRED EMBODIMENTS

The invention provides a portable apparatus for tablet electronic devices, which has the dual functions of a protective case and a stand for convenient operation. In particular, the portable apparatus of the invention can be quickly and conveniently converted to multiple three-dimensional structures to provide suitable support for the tablet electronic devices in landscape or portrait viewing position for viewing or other operations, such as taking photos.

Flexible protective covers for tablet devices that can be folded into stands are known. However, the usage of these protective covers is limited by the fact that they can only support tablet devices in one of the portrait and landscape viewing modes, but not both. As it may be desirable for a user to view a tablet device in the portrait mode for some applications and in the landscape mode for other applications, these protective covers unduly restrict the user's options. The present invention advantageously provides a protective cover capable of being folded diagonally to form a three dimensional structure to support the tablet device to be viewed in both the portrait and landscape modes.

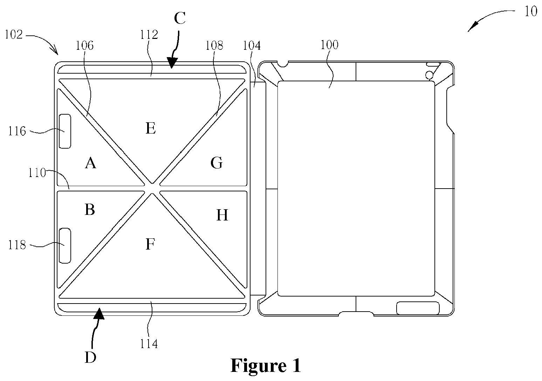

Referring to Fig. 1, shown therein is a portable apparatus 10 for a tablet portable electronic device such as tablet PCs and e-books. The portable apparatus 10 consists of a back cover 100, a front cover 102 and a connection member 104 between the front and back covers.

The back cover 100 is removably attached onto the back panel of the tablet portable device by an attachment mechanism. In one embodiment of the invention, the attachment mechanism comprises snaps. In another embodiment of the invention, the attachment mechanism comprises an adhesive or glue. In yet another embodiment, the attachment mechanism comprises VELCRO ® hook and loop fasteners.

Alternatively, the back cover 100 can be formed with a pocket that receives the tablet portable device and that has an open window which allows viewing of the display screen 120 of the device.

The connection member 104 is connected to a corresponding side in each of the back cover 100 and the front cover 102, thus enabling the front cover 102 to pivotally move with respect to the back cover 100. In an embodiment of the invention, the front cover 102 can pivot or rotate along the side through which it is connected to the back cover 100 to position the front cover 102 substantially overlapping the back cover 100 to encase the tablet portable electronic device. In one embodiment, the back cover 100 and the front cover 102 are essentially of the same size as the front or back face of the device. In another embodiment, the back cover 100 and the front cover 102 are slightly larger than the front or back face of the device so as to encase the device to provide better protection along the edges thereof when not in use.

The front cover 102 includes a plurality of cover segments A-H that can be bent along bending or folding structures to conform to different configurations. The segments are defined by the bending or folding structures, which include a first bendable structure 106 that extends between first opposite corners of the front cover 102 along a first diagonal; a second bendable structure 108 that extends between second opposite corners of the front cover 102 along a second diagonal that intersects the first diagonal, a third bendable structure 110 that extends across the center of the front cover 102 from the connection member 104 to the left edge, a fourth bendable structure 112 that extends across an upper portion of the front cover 102 near and parallel to the top edge, a fifth bendable structure 114 that extends across a lower portion of the front cover 102 near and parallel to the bottom edge. At least one pair of fastener elements 116,118 are located on cover segments A and B, respectively. Each of cover segments A, B, E, F, G and H are triangular in shape.

Cover segment A is defined between the left edge of the front cover 102 and bendable structures 106 and 110. Cover segment B is defined between the left edge of the front cover 102 and bendable structures 110 and 108. Segment A is positioned directly above segment B and has a common side 110 therebetween. Cover segment C is a lateral flap that is oriented parallel to the top edge of the front cover while segment D is a lateral flap that is oriented parallel to the bottom edge of the front cover. Segment E is defined between bendable structures 106, 108 and 112, while segment F is defined between bendable structures 106, 108 and 114. The apex of segments E and F meet at the intersection of the bendable structures 106 and 108. Segments G and H are similar to segments A and B except that they are located adjacent the connection member 104, with segment G defined between the connection member 104 and bendable structures 108 and 110, and segment H defined between the connection member 104 and bendable structures 110 and 106. Segment G is positioned directly above segment H and has a common side 110 therebetween.

In one embodiment, the fastener elements 116,118 are structures that can be repeatedly and removably fixed to serve the purpose of fastening. In one preferred embodiment, the fastener elements 116,118 comprises VELCRO ® hook and loop fasteners. In another preferred embodiment, the fastener elements 116,118 are a matching pair of a magnet and a magnetically responsive metal such as iron or steel. Fastener elements 116, 118 are preferably located on segments A and B in positions where they can mate or join after segments A and B are folded over bendable structure 110.

The bendable structures can be score lines in a cover of more durable material, or a resilient material that connects the cover segments and that is made of a material that is more easily bent or folded than the material of the cover or cover segments. The bendable structures may also be hinges.

The first bendable structure 106 and the second bendable structure 108, respectively, can be repeatedly bent along the respective diagonals of the front cover 102. The third bendable structure 110 can be repeatedly bent along the midline of the front cover 102. The fourth bendable structure 112 and the fifth bendable structure 114 can be repeatedly bent along the top and bottom sidelines of the front cover 102, respectively.

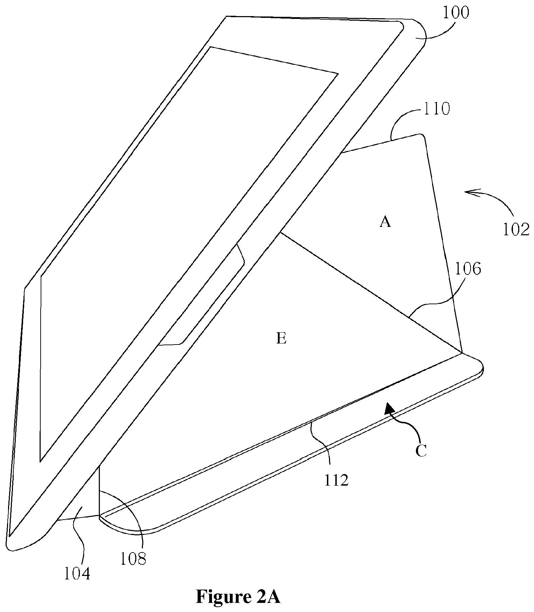

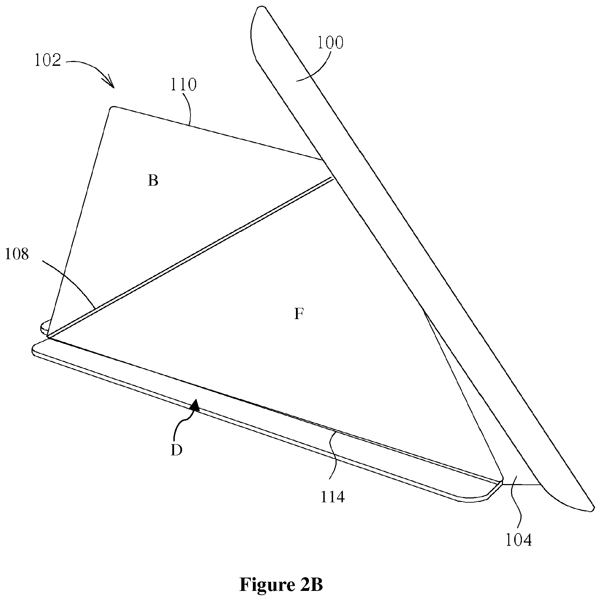

By means of folding the front cover 102 along one or more of the bendable structures 106,108,110,112,114, the portable apparatus 10 can maintain a three-dimensional standing position. This is facilitated by the connection of the segments by fastener elements 116 and 118 after bending, to support the tablet portable electronic device in either a horizontal or vertical standing position for viewing or other operations. In one embodiment, the front cover 102 is folded into a three-dimensional structure as shown in Figs. 2A and 2B, which show the left and right views of the same structure. As shown in those figures, the front cover 102 is first opened and then segments A and B are bent along the portion of bendable structure 110 that extends from the left edge of the cover to the intersection of the diagonals. These segments are bent until bendable structures 106 and 108 are in contact. The adjacent position of segments A and B is maintained by mating or joining of fastener members 116, 118. Then, flaps that act as segments C and D are bent outwardly along bendable structures 112 and 114, respectively, so that they can contact a flat surface, such as a table. Segments E, F, G and H form a three-dimensional triangular pyramid structure that has an open base, with segments E and F forming two sides and the combination of segments G and H forming the third side. Segments G and H, facing as well as contacting the back of the electronic device, are hidden from view. This front cover 102 thus forms a stable three-dimensional triangular pyramid structure that holds the electronic device in a landscape viewing position at a specific angle that facilitate the user's viewing and/or operation of the device without having to hold the device with one hand. This in turn facilitates operation of the device with both hands for Internet surfing, book reading, video or photo or slide show viewing and so on.

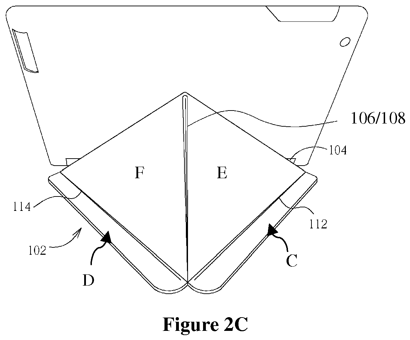

Alternatively, segments A and B can be folded downwardly so that they are placed within the three-dimensional triangular structure as shown in Fig. 2C. This is a more compact arrangement. As in Figs. 2A and 2B, the segments are held together by the fastening elements 116, 118. To facilitate the different types of connection, the fastening elements can be provided on both the inside and outside of the front cover 102.

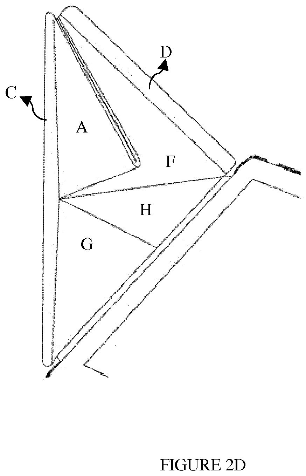

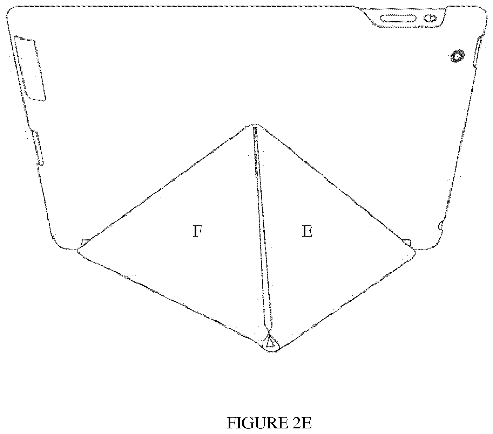

An alternative arrangement is shown in Figs. 2D and 2E, with Fig. 2D showing the inside view of the three-dimensional triangular structure formed by segments E, F, G and H and Fig. 2E providing the back view of the device resting on the three-dimensional triangular structure formed by segments E, F, G and H. In this three-dimensional triangular structure, segments E and F form two sides and the combination of segments G and H forms the third side, with the open side facing the back panel of the device. The third side formed by the combination of segments G and H contacts a flat surface, such as a table. Segments A and B are held together by the fastening elements 116, 118, and are folded inside the three-dimensional triangular structure. Flaps that act as segments C and D are inwardly bent along bendable structures 112 and 114, respectively, so that they contact the back cover of the portable apparatus 10 but are not visible (Fig. 2E). Alternatively, flaps that act as segments C and D are outwardly bent along bendable structures 112 and 114, respectively, so that they can contact the back cover of the portable apparatus 10 and are visible in the folded structure (Fig. 2D).

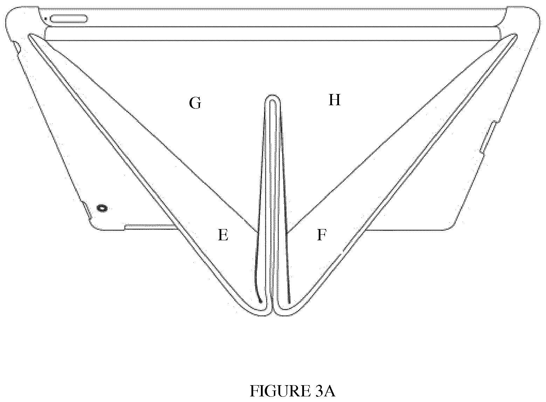

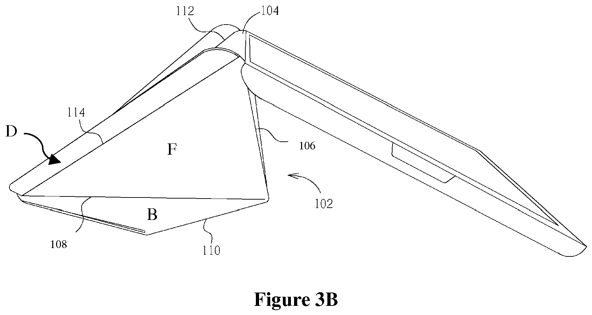

Two different arrangements are shown in Figs. 3A and 3B. In Figs. 2A-2E, the connection member 104 is positioned on the lower side of the tablet portable electronic device that rests on a flat horizontal surface such as a table, while in the embodiments shown in Figs. 3A and 3B, the connection member 104 is positioned along the upper side of the tablet portable electronic device. This means that the front cover 102 is first folded backwards from the back cover 100 and is placed in position so that the connection member 104 is placed in the highest position at the top of the apparatus. The three-dimensional structure formed by the front cover 102 can fix the tablet portable electronic device at a position where the angle with the table is much smaller so that the device is visible in a more inclined position.

First, segments A and B are folded together and joined by the fastening elements 116, 118. The folded combination can be placed either inside (Fig. 3A) or outside (Fig, 3B) the three-dimensional structure. Then, as shown in Fig. 3B, the folded combination is bent so that segments A/B can be placed on a flat surface to provide stability to the structure. Flaps C and D provide additional strength to the configuration. Unlike the configuration in Figs. 2A-2C, segments G and H do not contact the device but instead provide a vertical support for the connection member 104.

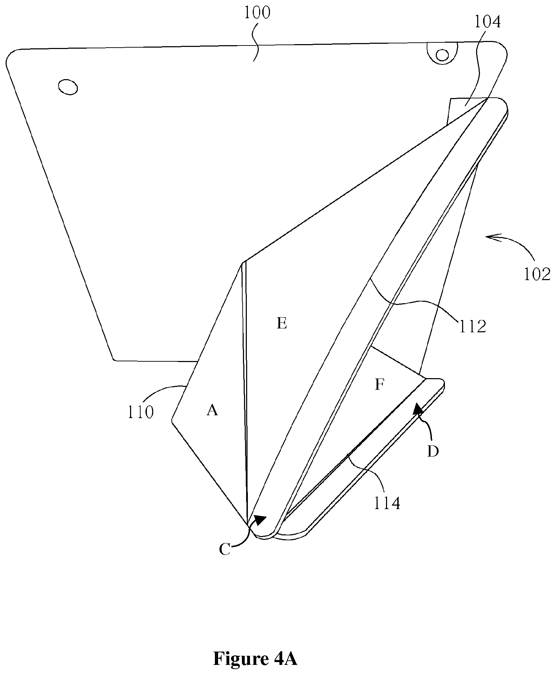

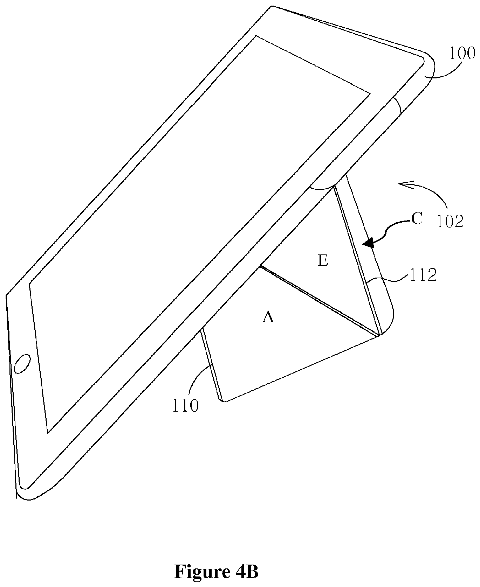

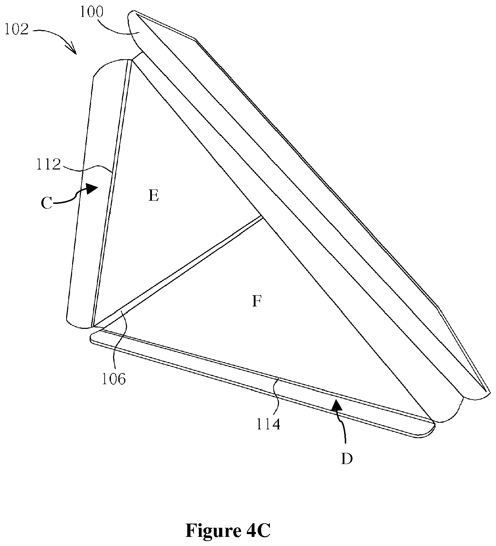

Moreover, as shown in Figs. 4A-4D, the tablet portable electronic device shown in Figs. 2A-2E can be rotated by 90 degrees to achieve a more vertical standing of the device. This simply places a different segment in contact with the table or support so that the device can be positioned with the smaller dimension horizontal and the larger dimension vertical. The three-dimensional structures formed by the front cover 102 support the tablet portable electronic device in the upright state, so as to meet operational needs or provide different viewing of the screen. As shown in Figs. 4A-4D, the front cover 102 is first opened and then segments A and B are bent along the portion of bendable structure 110 that extends from the left edge of the cover to the intersection of the diagonals. These segments are bent until bendable structures 106 and 108 are in contact. The adjacent position of segments A and B is maintained by mating or joining of fastener members 116, 118. Then, flaps that act as segments C and D are bent outwardly along bendable structures 112 and 114, respectively, with segment D contacting a flat surface, such as a table. Segments E, F, G and H form a three-dimensional triangular structure that has an open side, with segments E and F forming two sides and the combination of segments G and H forming the third side. The front cover 102 thus forms a stable three-dimensional triangular structure that holds the electronic device in a portrait viewing position at a specific angle that facilitate the user's viewing and/or operation of the device without having to hold the device with one hand. This in turn facilitates operation of the device with both hands for Internet surfing, book reading, video or photo or slide show viewing and so on.

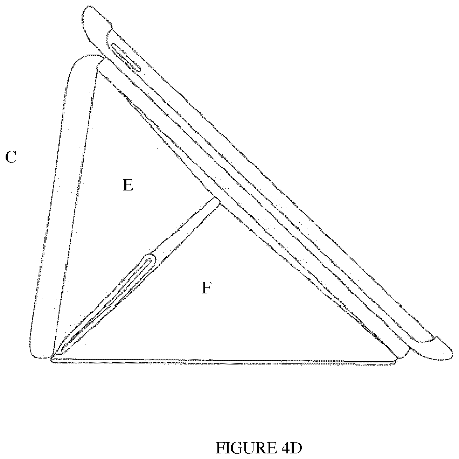

Alternatively, segments A and B can be folded inwardly so that they are placed within the three-dimensional triangular structure as shown in Fig. 4D. This is a more compact arrangement. As in Figs. 4A-4C, segments A/B are held together by the fastening elements 116, 118. To facilitate the different types of connection, the fastening elements can be provided on both the inside and outside of the front cover 102.

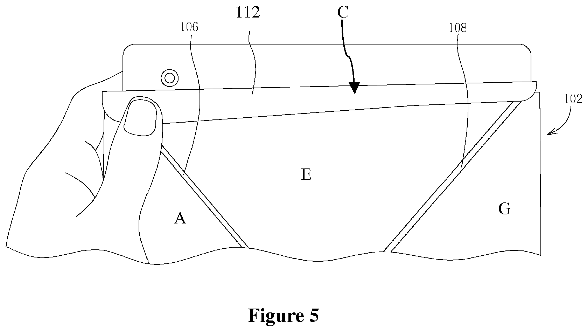

In the embodiments shown in Figs. 2A to 4D, the fourth bendable structure 112 and the fifth bendable structure 114 can form a three-dimensional structure with the front cover 102, providing additional support between the front cover and the flat surface it rests on, such as the desktop, so that the tablet portable electronic device can be more stable and firm for operation in the landscape or portrait viewing mode. In addition, by means of folding the fourth bendable structure 112, as in the embodiment shown in Fig. 5, the lens of the portable electronic devices which is typically present on the device will not be blocked. Thus, users do not need to take the tablet portable electronic device out of the portable apparatus 10 in order to use the front or back lens of the tablet portable electronic device at any time, which makes it more user-friendly.

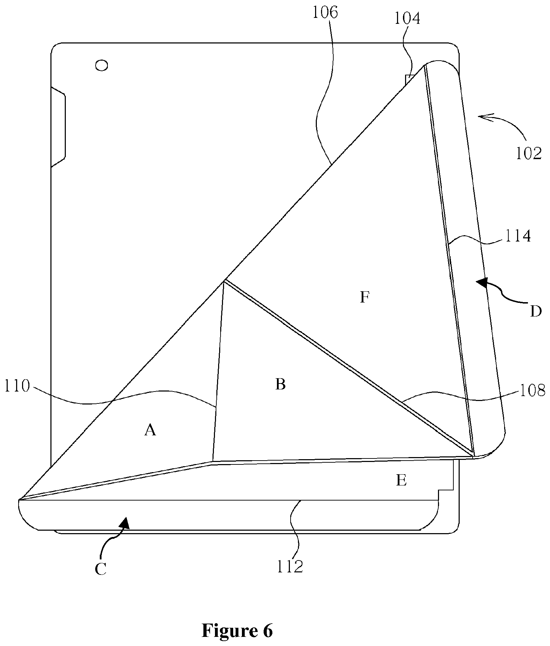

In the embodiment shown in Fig. 6, the front cover 102 was folded along the second bendable structure 108, so as not to block the lens on the back of the portable electronic device.

As exemplified in the embodiments shown in Figs. 1-6, the portable apparatus 10 not only can effectively protect the tablet portable electronic devices and, more importantly, but also can be quickly and conveniently converted into landscape or portrait viewing position. Thus, users can use lens located at both the front and the back panels of the portable tablet electronic device at any time, which in turn enhances user-friendliness.

In one embodiment, the surface of the back cover 100, the front cover 102 and the connection member 104 can be coated or made of rubber, silicone-related materials, fabrics (such as microfiber cloth, etc.), paperboard, cardboard, metal, sheet plastic, stiffened cloth, vinyl covered binder board, hardback book binding materials, molded plastic, leather, and carbon fiber epoxy composites, or other soft materials.

In another embodiment, the first bendable structure 106, the second bendable structure 108 and the third bendable structure 110 as well as the fourth bendable structure 112 and the fifth bendable structure 114 in the front cover 102 are all capable of repetitive bending, and the implementation can be properly adapted to the materials used.

In one embodiment, the appearance and the size of the portable apparatus 10 match those of the tablet portable electronic device.

In one embodiment, the fastener elements 116 and 118 are a magnet and a piece of iron, respectively. If the tablet portable electronic device can switch the operation state according to the magnetic polarity detected, the location of the magnet should be adjusted in relation to that of the magnet detector in the tablet portable electronic device, so as to ensure the proper operation of the device.

While the foregoing invention has been described in some detail for purposes of clarity and understanding, it will be appreciated by one skilled in the art, from a reading of the disclosure, that various changes and modifications in form and detail can be made without departing from the true scope of the invention, as long as this falls within the scope of the appended claims.

## Claims

1. A portable apparatus (10) for storing and selectively positioning a portable electronic device in one of a plurality of viewing or operational positions, comprising:
a front cover (102) made of a durable material and comprising first and second diagonals that extend between opposite corners of the front cover (102) and a midline extending across the center of the front cover (102) from the connection member (104) to the left edge that define a plurality of cover segments (A-H) that can be arranged in different positions to form three-dimensional structures for supporting the device by folding or bending the segments along the first and second diagonals and the midline;
a back cover (100) adapted for removable interconnection with the electronic device; and
a connection member (104) hingedly attached to each of the front and back covers (102, 100) to enable the apparatus (10) to transform between open and closed configurations;
wherein in the closed configuration the front cover (102) shields the face of the portable electronic device for storage or transport, while in the open, folded configuration, the three-dimensional structures formed by the folded front cover (102) act as supports for selectively positioning the portable electronic device in different arrangements for viewing or operation thereof, **characterized in that** the first and second diagonals and the midline are bendable structures that facilitate folding or bending to alter the position of the cover segments (A-H).

2. The portable apparatus (10) of claim 1, wherein the bendable structures comprise score lines in the material of the cover or cover segments, or a hinge or resilient material that connects the cover segments (A-H) wherein the resilient material is more easily bent or folded than the material of the cover or cover segments (A-H).

3. The portable apparatus (10) of claim 1, wherein each of the front and back covers has essentially the same dimension as that of the electronic device for compact engagement therewith.

4. The portable apparatus (10) of claim 1, wherein the front and back covers have larger dimensions than the electronic device to provide additional protection against damage to the edges of the device.

5. The portable apparatus (10) of claim 1, wherein at least two segments of the front cover (102) include fastening elements (116,118) positioned for mating contact to hold the folded segments together after folding to assist in maintaining the three-dimensional structures.

6. The portable apparatus (10) of claim 5, wherein the fastening elements (116,118) include a magnet and a metal that is capable of magnetic attraction to the magnet.

7. The portable apparatus (10) of claim 5, wherein the fastening elements (116,118) are hook and loop fasteners.

8. The portable apparatus (10) of claim 1, wherein the device is rectangular, and the three-dimensional structures position the device for viewing in portrait or landscape mode and at different viewing angles.

9. The portable apparatus (10) of claim 1, wherein the three-dimensional structure of the front cover (102) provides support for the back cover (100) to stand with a tilt angle so that, when the electronic device is attached to the back cover (100) via an attachment mechanism, it can operate in a landscape or portrait viewing position.

10. The portable apparatus (10) of claim 9, wherein the attachment mechanism includes an adhesive, one or more clips or a pocket that receives the electronic device.

11. The portable apparatus (10) of claim 1, wherein the durable material of the front cover (102) is rubber, silicone, fabric, cardboard, metal, plastic, stiffened cloth, vinyl covered binder board, hardback book binding materials, leather, or a carbon fiber epoxy composite.

12. The portable apparatus (10) according to any of claims 1 - 11, wherein the plurality of cover segments (A-H) are further defined by a fourth bendable structure (112) extending across an upper portion of the front cover (102) near and parallel to the top edge, and a fifth bendable structure (114) extending across a lower portion of the front cover (102) near and parallel to the bottom edge.

13. The combination of a portable electronic device and the portable apparatus (10) of claim 1.

14. The combination of claim 13, wherein the device is a tablet that includes a touch screen and at least one camera lens.

15. The combination of claim 13, wherein the front cover (102) is foldable to expose at least one camera lens of the electronic device.

16. The combination of claim 13, wherein the portable apparatus (10) includes means for attaching the electronic device thereto.

17. The combination of claim 16, wherein the attaching means includes an adhesive, one or more clips or a pocket that receives the electronic device.

18. The combination of claim 13, wherein the durable material of the front cover (102) is rubber, silicone, fabric, cardboard, metal, plastic, stiffened cloth, vinyl covered binder board, hardback book binding materials, leather, or a carbon fiber epoxy composite.

## Patentansprüche

1. Tragbare Vorrichtung (10) zur Speicherung und selektiven Positionierung eines tragbaren elektronischen Geräts in einer von mehreren Betrachtungs- oder Betriebspositionen, bestehend aus:
einer Frontabdeckung (102), die aus einem haltbaren Material hergestellt ist und erste und zweite Diagonalen umfasst, die sich zwischen gegenüberliegenden Ecken der Frontabdeckung (102) und einer Mittellinie erstrecken, die sich über die Mitte der Frontabdeckung (102) vom Verbindungselement (104) zur linken Kante erstreckt, die eine Vielzahl von Abdecksegmenten (A-H) definiert, die in verschiedenen Positionen angeordnet werden können, um dreidimensionale Strukturen zum Tragen des Geräts durch Klappen oder Biegen der Segmente entlang der ersten und zweiten Diagonale und der Mittellinie zu bilden;
einer hinteren Abdeckung (100), die zur entfernbaren Verbindung mit dem elektronischen Gerät ausgelegt ist; und ein Verbindungselement (104), das gelenkig an jeder der Front- und hinteren Abdeckungen (102, 100) angebracht ist, um zu ermöglichen, dass die Vorrichtung (10) zwischen einer offenen und einer geschlossenen Konfiguration wechselt;
wobei in der geschlossenen Konfiguration die Frontabdeckung (102) die Fläche des tragbaren elektronischen Geräts zum Aufbewahren oder Transportieren abschirmt, während in der offenen, aufgeklappten Konfiguration die dreidimensionalen Strukturen, die durch die geklappten Frontabdeckung (102) gebildet werden, als Träger zum selektiven Positionieren des tragbaren elektronischen Geräts in verschiedenen Anordnungen zum Betrachten oder Bedienen derselben dienen, **dadurch gekennzeichnet sind, dass** die erste und zweite Diagonale und die Mittellinie biegsame Strukturen sind, die das Klappen oder Biegen erleichtern, um die Position der Abdecksegmente (A-H) zu ändern.

2. Tragbare Vorrichtung (10) nach Anspruch 1, wobei die biegbaren Strukturen Kerblinien in dem Material der Abdeckung oder der Abdecksegmente oder ein Gelenk oder ein elastisches Material umfassen, das die Abdecksegmente (A-H) verbindet, wobei das elastische Material leichter gebogen oder geklappt wird als das Material der Abdeckung oder der Abdecksegmente (A-H).

3. Tragbare Vorrichtung (10) nach Anspruch 1, wobei die Front- und die hintere Abdeckung im Wesentlichen die gleichen Abmessungen aufweisen wie die des elektronischen Geräts, um damit kompakt in Eingriff zu kommen.

4. Tragbare Vorrichtung (10) nach Anspruch 1, wobei die Front- und hintere Abdeckung größere Abmessungen als das elektronische Gerät aufweisen, um einen zusätzlichen Schutz gegen Beschädigung der Kanten des Geräts bereitzustellen.

5. Tragbare Vorrichtung (10) nach Anspruch 1, wobei mindestens zwei Segmente der Frontabdeckung (102) Befestigungselemente (116, 118) beinhalten, die für den Gegenkontakt positioniert sind, um die geklappten Segmente nach dem Klappen zusammenzuhalten, um beim Halten der dreidimensionalen Strukturen zu helfen.

6. Tragbare Vorrichtung (10) nach Anspruch 5, wobei die Befestigungselemente (116, 118) einen Magneten und ein Metall beinhalten, das den Magneten magnetisch anziehen kann.

7. Tragbare Vorrichtung (10) nach Anspruch 5, wobei die Befestigungselemente (116, 118) Klettverschlüsse sind.

8. Tragbare Vorrichtung (10) nach Anspruch 1, wobei das Gerät rechteckig ist und die dreidimensionalen Strukturen das Gerät zum Betrachten im Hoch- oder Querformat und in verschiedenen Blickwinkeln positionieren.

9. Tragbare Vorrichtung (10) nach Anspruch 1, wobei die dreidimensionale Struktur der Frontabdeckung (102) eine Stütze für die hintere Abdeckung (100) bereitstellt, um mit einem Neigungswinkel zu stehen, sodass das elektronische Gerät, wenn es über einen Befestigungsmechanismus an der hinteren Abdeckung (100) befestigt ist, in einer Hoch- oder Querformatansicht betrieben werden kann.

10. Tragbare Vorrichtung (10) nach Anspruch 9, wobei der Befestigungsmechanismus einen Klebstoff, eine oder mehrere Klemmen oder eine Tasche, die das elektronische Gerät aufnimmt, beinhaltet.

11. Tragbare Vorrichtung (10) nach Anspruch 1, wobei das haltbare Material der Frontabdeckung (102) Gummi, Silikon, Stoff, Pappe, Metall, Kunststoff, ausgesteifter Stoff, vinylbeschichtete Bindemittelplatte, Hardcover-Buchbindematerialien, Leder oder ein Kohlefaser-Epoxid-Verbundstoff ist.

12. Tragbare Vorrichtung (10) nach einem der Ansprüche 1 - 11, wobei die Vielzahl von Abdecksegmenten (A-H) weiter durch eine vierte biegsame Struktur (112) definiert ist, die sich über einen oberen Abschnitt der Frontabdeckung (102) nahe und parallel zu der Oberkante erstreckt, und eine fünfte biegsame Struktur (114), die sich über einen unteren Abschnitt der Frontabdeckung (102) nahe und parallel zu der Unterkante erstreckt.

13. Kombination aus einem tragbaren elektronischen Gerät und der tragbaren Vorrichtung (10) nach Anspruch 1.

14. Kombination nach Anspruch 13, wobei das Gerät ein Tablet ist, das einen Touchscreen und mindestens ein Kameraobjektiv beinhaltet.

15. Kombination nach Anspruch 13, wobei die Frontabdeckung (102) klappbar ist, um mindestens ein Kameraobjektiv des elektronischen Geräts freizulegen.

16. Kombination nach Anspruch 13, wobei die tragbare Vorrichtung (10) Mittel zum Anbringen des elektronischen Geräts daran beinhaltet.

17. Kombination nach Anspruch 16, wobei das Befestigungsmittel einen Klebstoff, eine oder mehrere Klemmen oder eine Tasche, die das elektronische Gerät aufnimmt, beinhalten.

18. Kombination nach Anspruch 13, wobei das haltbare Material der Frontabdeckung (102) Gummi, Silikon, Stoff, Pappe, Metall, Kunststoff, ausgesteifter Stoff, vinylbeschichtete Bindemittelplatte, Hardcover-Buchbindematerialien, Leder oder ein Kohlefaser-Epoxid-Verbundstoff ist.

## Revendications

1. Appareil portable (10) pour le stockage et le positionnement sélectif d'un dispositif électronique portable dans l'une des diverses positions de visionnage ou d'utilisation, comprenant :
un couvercle avant (102) en matériau durable et comprenant une première et une seconde diagonale qui s'étendent entre les coins opposés du couvercle avant (102) et une ligne médiane s'étendant à travers le centre du couvercle avant (102) de l'élément de connexion (104) jusqu'au bord gauche qui définissent une pluralité de segments de couvercle (A-H) qui peuvent être disposés en différentes positions pour former des structures tridimensionnelles pour le support du dispositif par le pliage ou la courbure des segments le long de la première et de la seconde diagonale ainsi que de la ligne médiane ;
un couvercle arrière (100) adapté pour l'interconnexion amovible avec le dispositif électronique ; et un élément de connexion (104) fixé de manière articulée aux couvercles avant et arrière (102, 100) pour permettre à l'appareil (10) d'alterner entre des configurations ouverte et fermée ;
dans la configuration fermée, le couvercle avant (102) protège la face du dispositif électronique portable pour le rangement ou le transport, tandis que dans la configuration pliée ouverte, les structures tridimensionnelles formées par le couvercle avant plié (102) agissent comme des supports pour le positionnement sélectif du dispositif électronique portable dans différentes dispositions pour le visionnage ou l'utilisation de celui-ci, **caractérisé en ce que** la première et la seconde diagonale et la ligne médiane sont des structures pliables qui facilitent le pliage ou l'incurvation pour modifier la position des segments du couvercle (A-H).

2. Appareil portable (10) selon la revendication 1, dans lequel les structures pliables comprennent des lignes de repère dans le matériau du couvercle ou des segments de couvercle, ou une charnière ou un matériau résilient qui relie les segments de couvercle (A-H) où le matériau résilient est plus facilement plié ou incurvé que le matériau du couvercle ou des segments de couvercle (A-H).

3. Appareil portable (10) selon la revendication 1, dans lequel chacun des couvercles avant et arrière a essentiellement la même dimension que celle du dispositif électronique pour un emboîtement compact avec celui-ci.

4. Appareil portable (10) selon la revendication 1, dans lequel les couvercles avant et arrière ont des dimensions plus importantes que le dispositif électronique pour assurer une protection supplémentaire contre l'endommagement des bords du dispositif.

5. Appareil portable (10) selon la revendication 1, dans lequel au moins deux segments du couvercle avant (102) incluent des éléments de fixation (116, 118) positionnés pour que le contact correspondant maintienne les segments pliés ensemble après le pliage pour aider à maintenir les structures tridimensionnelles.

6. Appareil portable (10) selon la revendication 5, dans lequel les éléments de fixation (116, 118) incluent un aimant et un métal capable d'appliquer une attraction magnétique sur l'aimant.

7. Appareil portable (10) selon la revendication 5, dans lequel les éléments de fixation (116, 118) sont des fixations par crochets et boucles.

8. Appareil portable (10) selon la revendication 1, dans lequel le dispositif est rectangulaire et les structures tridimensionnelles positionnent le dispositif pour un visionnage en mode portrait ou paysage et à des différents angles de visionnage.

9. Appareil portable (10) selon la revendication 1, dans lequel la structure tridimensionnelle du couvercle avant (102) fournit un support pour que le couvercle arrière (100) se tienne à un angle d'inclinaison tel que, lorsque le dispositif électronique est fixé au couvercle arrière (100) au moyen d'un mécanisme de fixation, il peut fonctionner dans une position de visionnage en mode paysage ou portrait.

10. Appareil portable (10) selon la revendication 9, dans lequel le mécanisme de fixation inclut un adhésif, une ou plusieurs attaches ou une poche qui reçoit le dispositif électronique.

11. Appareil portable (10) selon la revendication 1, dans lequel le matériau durable du couvercle avant (102) est du caoutchouc, du silicone, du tissu, du carton, du métal, du plastique, du tissu rigidifié, un panneau liant recouvert de vinyle, des matériaux de reliure de livre à couverture rigide, du cuir ou un composite époxy en fibre de carbone.

12. Appareil portable (10) selon l'une des revendications 1 à 11, dans lequel la pluralité des segments du couvercle (A-H) sont définis plus précisément par une quatrième structure pliable (112) s'étendant à travers une partie supérieure du couvercle avant (102) à proximité et de manière parallèle au bord supérieur, et une cinquième structure pliable (114) s'étendant à travers une partie inférieure du couvercle avant (102) à proximité et de manière parallèle au bord inférieur.

13. Combinaison d'un dispositif électronique portable et de l'appareil portable (10) selon la revendication 1.

14. Combinaison selon la revendication 13, où le dispositif est une tablette à écran tactile et au moins un objectif d'appareil photo.

15. Combinaison selon la revendication 13, où le couvercle avant (102) est pliable pour exposer au moins un objectif d'appareil photo du dispositif électronique.

16. Combinaison selon la revendication 13, où l'appareil portable (10) inclut un moyen pour la fixation du dispositif électronique.

17. Combinaison selon la revendication 16, où le moyen de fixation inclut un adhésif, une ou plusieurs attaches ou une poche pour recevoir le dispositif électronique.

18. Combinaison selon la revendication 13, où le matériau durable du couvercle avant (102) est du caoutchouc, du silicone, du tissu, du carton, du métal, du plastique, du tissu rigidifié, un panneau liant recouvert de vinyle, des matériaux de reliure de livre à couverture rigide, du cuir ou un composite époxy en fibre de carbone.
